# EUROPEAN PATENT APPLICATION

(11) **EP 4 738 358 A1**
(43) Date of publication of application: **06.05.2026**
(21) Application number: 25209813.2
(22) Date of filing: 20.10.2025
(51) Int. Cl.: G11C 7/04, G11C 7/08, G11C 13/00, G11C 29/02

(54) **OPTIMIZED SINGLE ENDED EPCM READ METHODOLOGY ADAPTIVE TO TEMPERATURE VARIATIONS**

(30) Priority: 31.10.2024 US 202463714291 P; 15.10.2025 US 202519359164
(71) Applicant: STMicroelectronics International N.V., 1228 Plan-les-Ouates, Geneva (CH)
(72) Inventor: JAIN, Abhishek, 201301 Noida (IN); JAIN, Shubham, 473551 Shivpuri (IN)
(74) Representative: Casalonga

(57) **Abstract**

Readout circuitry for embedded phase change memory (ePCM) cells is disclosed. The circuitry includes a temperature sensor that outputs a signal indicating whether the sensed temperature is above or below a threshold. A microcontroller generates read and trim signals, with the trim signal based on the temperature signal. A phase generation circuit receives these signals and generates precharge and evaluation signals based on the trim signal. A sense amplifier, controlled by the precharge and evaluation signals, compares the ePCM cell current to a reference current to generate an output. The circuitry dynamically adjusts its timing parameters in response to temperature changes, providing for reliable read operations across varying conditions.

## Description

### TECHNICAL FIELD

This disclosure relates to the field of embedded Phase Change Memory (ePCM) devices. Specifically, it addresses improvements in read operations for ePCM cells across varying temperature conditions through improved readout circuitry.

### BACKGROUND

Embedded Phase Change Memory (ePCM) is a type of non-volatile memory that has gained attention in recent years due to its potential for high-density storage and fast read/write operations. In ePCM devices, information is stored by changing the physical state of a chalcogenide material between amorphous (high resistance) and crystalline (low resistance) states.

The read operation for a given ePCM cell typically relies on a comparison of the current flowing through the ePCM cell (ICELL) with a reference current (IREF). This comparison allows the system to determine the logical state of the cell. The cell current ICELL is generated by applying a small read voltage across the ePCM cell and measuring the resulting current. The magnitude of the cell current ICELL depends on the resistance state of the cell, which corresponds to the stored data bit (0 or 1).

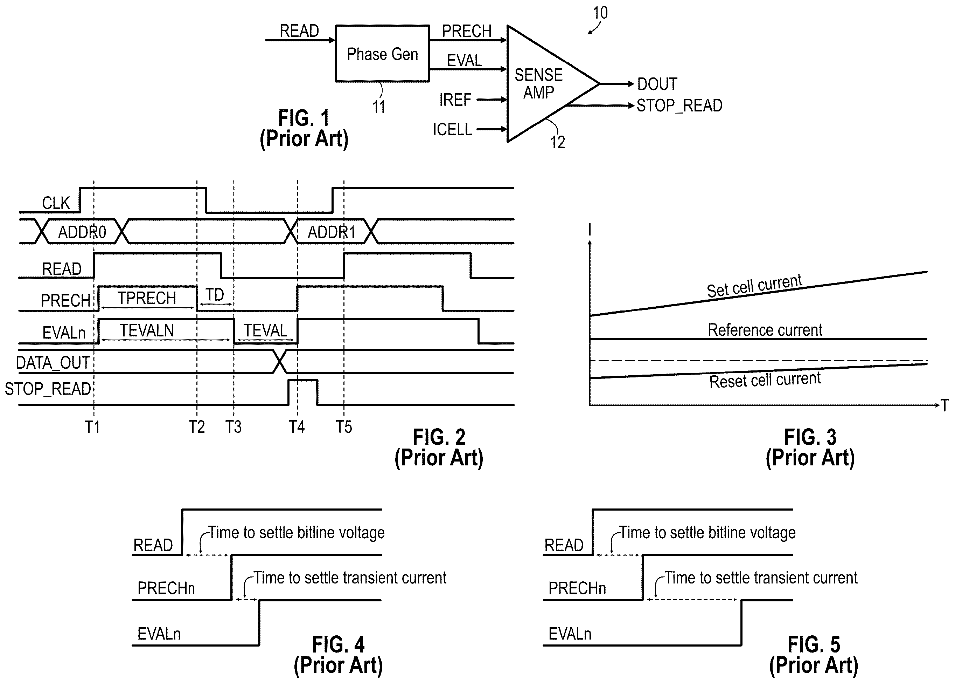

A sample readout circuit 10 for an ePCM cell is shown in FIG. 1. The circuit includes a sense amplifier 12 that receives the cell current ICELL from the ePCM cell along with the reference current IREF. The reference current IREF is typically generated by a separate reference circuit and is set to a value between the expected currents for the low and high resistance states of the ePCM cell.

The sense amplifier 12 is controlled by a precharge signal PRECH and an evaluation signal EVAL, which are generated by the phase generation circuitry 11. The phase generation circuitry 11 produces the PRECH and EVAL signals in response to the assertion of a read signal READ, indicating that the ePCM cell is to be read.

During the read operation, the sense amplifier 12 compares the current ICELL to the current IREF. If the current ICELL is greater than the current IREF, it indicates that the ePCM cell is in a low resistance state (crystalline), typically representing a logical '1'. Conversely, if the current ICELL is less than the current IREF, it suggests the cell is in a high resistance state (amorphous), usually representing a logical '0'. The result of this comparison is then output as a data output signal DOUT, providing the logical value stored in the ePCM cell.

FIG. 2 illustrates the timing diagram of a typical read operation. At time T1, after the rising edge of a clock signal CLK (which occurs prior to time T1), the READ signal is asserted, and the address ADDR0 of the cell to be read becomes valid. The precharge signal PRECH is then asserted by the phase generation circuitry 11 to begin precharging the sense amplifier 12, and the negated evaluation signal EVALN is deasserted (active low). The precharge operation continues for a duration TPRECH of the precharge signal PRECH, ending at time T2. During this time, the sense amplifier is prepared for the subsequent evaluation phase.

There is a brief delay TD before the evaluation phase begins at time T3. At this point, the negated evaluation signal EVALN is asserted (active low, thus corresponding to active high assertion of the evaluation signal EVAL), initiating the comparison between the currents ICELL and IREF. The evaluation phase lasts for a duration TEVAL, which ends at time T4. During this duration, the sense amplifier 12 compares the current ICELL to the current IREF to determine the logical state of the ePCM cell. Near the end of this phase, the data output signal DATA_OUT becomes valid, representing the result of the comparison.

At time T5, the stop read signal STOP_READ is asserted, indicating the completion of the read operation. Shortly after, the system prepares for the next read operation, with the address changing to ADDR1 for the subsequent read cycle having been loaded at time T4.

In ePCM devices, accurate reading of cell states requires a minimum current window of typically 1 µA between the array cell current and the reference current. This current window is needed for the sense amplifier to reliably distinguish between the set (low resistance) and reset (high resistance) states of the memory cell. However, maintaining consistent read operations across a wide temperature range presents a significant challenge in ePCM technology.

As illustrated in FIG. 3, the cell current ICELL in ePCM devices is not constant with respect to temperature. Instead, it exhibits a positive temperature coefficient, increasing as temperature rises. This temperature-dependent behavior creates several issues that complicate the read process.

Firstly, there is the problem of current window reduction. This is explained in the context of the cell current ICELL, the set cell current, and the reset cell current - ICELL represents the current flowing through the ePCM cell during a read operation, and its value depends on whether the cell is in a set or reset state. The set cell current corresponds to ICELL when the cell is in a low resistance state (e.g., a logical '1'), while the reset cell current corresponds to ICELL when the cell is in a high resistance state (e.g., a logical '0').

To turn now to the aforementioned problem of current window reduction, if the reference current IREF is kept constant while the cell current ICELL varies with temperature, the current difference window between the cell current and reference current can decrease significantly at certain temperatures. This is evident in FIG. 3, where the gap between the set cell current and the reference current widens as temperature increases, while the gap between the reset cell current and the reference current narrows as temperature increases. This means that as temperature rises, a set cell becomes easier to distinguish from the reference, while a reset cell becomes more difficult to distinguish.

This varying current window can lead to potential read failures. When the current difference becomes less than the offset of the current comparator (sense amplifier 12), there is a possibility of misreading the cell state. This is particularly problematic at temperature extremes, where the current window may be at its narrowest. Specifically, at high temperatures, there is a risk of misreading a reset cell as a set cell, while at low temperatures, there is a risk of misreading a set cell as a reset cell.

Furthermore, silicon data from technology teams demonstrates that read windows change with temperature. In current implementations, the worst reading window is typically achieved at -40°C, where the cell currents are at their lowest, making it particularly challenging to distinguish between the set and reset states as both current ICELL values (for set and reset) are closer to each other and to the reference current."

The timing diagrams in FIG. 4 and FIG. 5 illustrate another aspect of the challenge: the time required for the read operation to complete reliably. In both figures, we see the sequence of the signals READ, PRECHn (precharge), and EVALn (evaluate). The key difference lies in the time allowed for settling the transient current.

In FIG. 4, the time between the rising edge of the negated precharge signal PRECHn and the falling edge of the negated evaluation EVALn signal is relatively short (e.g., 0.2ns), as is the time between the rising edge of the READ signal and the EVAL signal (e.g., 7ns). This timing represents a good compromise for operation at, for example, 25°C, however, if this timing were to be used at low temperatures (e.g., -40°C), it could lead to read errors. As explained, at lower temperatures, the cell currents are lower and take longer to stabilize. The short evaluation time might not allow sufficient settling of the transient currents, potentially causing the sense amplifier 12 to sample the cell state before it has fully developed. This could result in misreading the state of the cell.

FIG. 5 shows an extended time for settling the transient current. Here, the time between the rising edge of the negated precharge PRECHn signal and the falling edge of the negated evaluation EVALn signal is relatively long (e.g., 9ns), as is the time between the rising edge of the read signal READ and the evaluation EVAL signal (e.g., 16ns). This timing represents a good compromise for operation at, for example, -40°C. However, it comes at the cost of increased read time, which can impact overall memory performance.

These temperature-related challenges underscore the need for more sophisticated read schemes in ePCM devices. Potential solutions might involve temperature-compensated reference currents, adaptive timing controls, or more advanced sense amplifier designs capable of handling wider variations in cell currents. Addressing these issues is of interest for improving the reliability and performance of ePCM technology across diverse operating conditions. As such, further development is needed.

### SUMMARY

According to one aspect, a readout circuit for an embedded phase change memory (ePCM) cell includes a temperature sensor that outputs a temperature signal indicating whether a sensed temperature is above or below a threshold temperature. A microcontroller generates a read signal and a trim signal, where the trim signal is generated based upon the temperature signal. A phase generation circuit is coupled to the microcontroller and receives the read signal and the trim signal, and generates a precharge signal and an evaluation signal based thereupon. A sense amplifier is coupled to the phase generation circuit to receive the precharge signal and the evaluation signal, where the sense amplifier compares a cell current from the ePCM cell to a reference current and generates an output signal based on the comparison, under timing control of the precharge signal and the evaluation signal.

The phase generation circuit may set a duration of time between deassertion of the precharge signal and assertion of the evaluation signal based on the trim signal.

The temperature sensor may be hysteretic to prevent rapid oscillations in the temperature signal due to small temperature fluctuations near the threshold temperature.

The microcontroller may set the trim signal to indicate insertion of a wait state based on the trim signal, where the wait state causes skipping of transition of the evaluation signal during a current read cycle.

The phase generation circuit may comprise: a first delay circuit configured to generate the precharge signal; and a second delay circuit configured to generate the evaluation signal.

The first delay circuit may comprise: a first capacitor; a first adjustable current source coupled to the first capacitor and configured to discharge the first capacitor; and a first set of inverters coupled to the first capacitor and configured to generate the precharge signal based on a voltage across the first capacitor.

The second delay circuit may comprise: a second capacitor; a second adjustable current source coupled to the second capacitor and configured to discharge the second capacitor; and a second set of inverters coupled to the second capacitor and configured to generate the evaluation signal based on a voltage across the second capacitor.

The first and second adjustable current sources may be configured to be adjusted based on the trim signal received from the microcontroller.

Adjusting the first and second adjustable current sources based on the trim signal may control the delay between the deassertion of the precharge signal and the assertion of the evaluation signal.

The second delay circuit may be triggered by a transition of the precharge signal.

The phase generation circuit may further comprise: a first logic circuit coupled to the first delay circuit and configured to control the assertion and deassertion of the precharge signal; and a second logic circuit coupled to the second delay circuit and configured to control the assertion and deassertion of the evaluation signal.

The first logic circuit may comprise: a first NOR gate having inputs receiving the precharge signal and an output of a second NOR gate; a first NAND gate having inputs receiving a stop read signal and a data output signal; a third NOR gate having inputs receiving an output of the first NAND gate and the precharge signal; and wherein the second NOR gate has inputs receiving an output of the third NOR gate and an output of the first delay circuit.

The second logic circuit may comprise: a second NAND gate having inputs receiving an inverted precharge signal and an output of the second delay circuit; and an inverter coupled to an output of the second NAND gate and configured to generate the evaluation signal.

According to another aspect, a readout circuit for a memory cell includes a temperature sensor that outputs a temperature signal indicating a sensed temperature. A timing control circuit is coupled to the temperature sensor and receives the temperature signal, generates a precharge signal and an evaluation signal for reading the memory cell, and adjusts a duration of time between deassertion of the precharge signal and assertion of the evaluation signal based on the temperature signal. A sense amplifier is coupled to the timing control circuit to receive the precharge signal and the evaluation signal, where the sense amplifier compares a cell current from the memory cell to a reference current and generates an output signal based on the comparison, under timing control of the precharge signal and the evaluation signal.

The timing control circuit may increase the duration of time between deassertion of the precharge signal and assertion of the evaluation signal when the sensed temperature is below a threshold temperature.

The temperature sensor may be hysteretic to prevent rapid oscillations in the temperature signal due to small temperature fluctuations near a threshold temperature.

The timing control circuit may further be configured to: insert a wait state based on the temperature signal, the wait state causing skipping of transition of the evaluation signal during a current read cycle.

According to another aspect, a readout circuit for an embedded phase change memory cell includes a microcontroller that latches a plurality of test addresses spanning the ePCM cell, performs both a slow read operation and a normal read operation at each of the plurality of test addresses, compares results of the slow read operation and the normal read operation at each test address, generates a temperature signal based on whether the slow read operation matches the normal read operation at each test address, and generates a trim signal based upon the temperature signal. A phase generation circuit is coupled to the microcontroller and receives the read signal and the trim signal, and generates a precharge signal and an evaluation signal based thereupon. A sense amplifier is coupled to the phase generation circuit to receive the precharge signal and the evaluation signal, where the sense amplifier compares a cell current from the ePCM cell to a reference current and generates an output signal based on the comparison, under timing control of the precharge signal and the evaluation signal.

The plurality of test addresses may include a lower address in the ePCM cell, a higher address in the ePCM cell, and an intermediate address between the lower address and the higher address.

The microcontroller may be configured to: set the temperature signal to a first value when the slow read operation matches the normal read operation at all test addresses; and set the temperature signal to a second value when the slow read operation differs from the normal read operation at any test address.

The first value may indicate operation above a threshold temperature; and the second value may indicate operation below the threshold temperature.

According to another aspect, a readout circuit for a memory cell comprises: a sense amplifier configured to compare a cell current from the memory cell to a reference current and to generate an output signal based on the comparison; a timing control circuit coupled to the sense amplifier and configured to generate a precharge signal and an evaluation signal controlling the sense amplifier; wherein the timing control circuit adjusts a duration of time between deassertion of the precharge signal and assertion of the evaluation signal based on a temperature-dependent control signal, such that the readout circuit adapts its read timing in response to temperature variations.

The temperature-dependent control signal may be generated by a temperature sensor having hysteresis around a threshold temperature.

The timing control circuit may insert a wait state in a read cycle when the temperature-dependent control signal indicates a temperature below a threshold temperature.

The timing control circuit may comprise a phase generation circuit having adjustable current sources configured to set the timing of the precharge signal and the evaluation signal based on the temperature-dependent control signal.

The readout circuit may further comprise a microcontroller configured to generate a trim signal based on the temperature-dependent control signal, the trim signal being applied to the timing control circuit to modify the duration between the precharge and evaluation signals.

### BRIEF DESCRIPTION OF THE DRAWINGS

FIG. 1 is a block diagram of a sample readout circuit for a known ePCM cell.
FIG. 2 is a timing diagram of a typical read operation for a known ePCM cell.
FIG. 3 is a timing diagram showing the temperature-dependent behavior of cell current in known ePCM devices.
FIG. 4 is a timing diagram showing a short settling time for transient current in the known ePCM cell.
FIG. 5 is a timing diagram showing an extended settling time for transient current in the known ePCM cell.
FIG. 6 is a schematic diagram of an improved sense amplifier for use in reading an ePCM cell.
FIG. 7 illustrates a block diagram of a readout circuit for an ePCM cell, the readout circuit being disclosed herein.
FIG. 8 is a detailed timing diagram showing the relationship between various signals during read operations of the ePCM memory cell of FIG. 7.
FIG. 9 is a schematic diagram of the phase generation circuitry used in the readout circuit of FIG. 7.
FIG. 10 is a timing diagram illustrating the relationship between various signals during the initial phase of a read operation of the readout circuit of FIG. 7.
FIG. 11 is a timing diagram showing a more detailed view of the subsequent phases of a read operation of the readout circuit of FIG. 7.
FIG. 12 illustrates a block diagram of a readout circuit for an ePCM cell, the readout circuit being disclosed herein, in which a thermal calibration procedure is implemented in order to determine the appropriate setting for THIS_OUT.
FIG. 13 is a flowchart of the method of determining the appropriate setting for THS_OUT.

### DETAILED DESCRIPTION

The following disclosure enables a person skilled in the art to make and use the subject matter described herein. The general principles outlined in this disclosure can be applied to embodiments and applications other than those detailed above without departing from the spirit and scope of this disclosure. It is not intended to limit this disclosure to the embodiments shown, but to accord it the widest scope consistent with the principles and features disclosed or suggested herein.

Note that in the following description, any resistor or resistance mentioned is a discrete device, unless stated otherwise, and is not simply an electrical lead between two points. Therefore, any resistor or resistance connected between two points has a higher resistance than a lead between those two points, and such resistor or resistance cannot be interpreted as a lead. Similarly, any capacitor or capacitance mentioned is a discrete device, unless stated otherwise, and is not a parasitic element, unless stated otherwise. Additionally, any inductor or inductance mentioned is a discrete device, unless stated otherwise, and is not a parasitic element, unless stated otherwise.

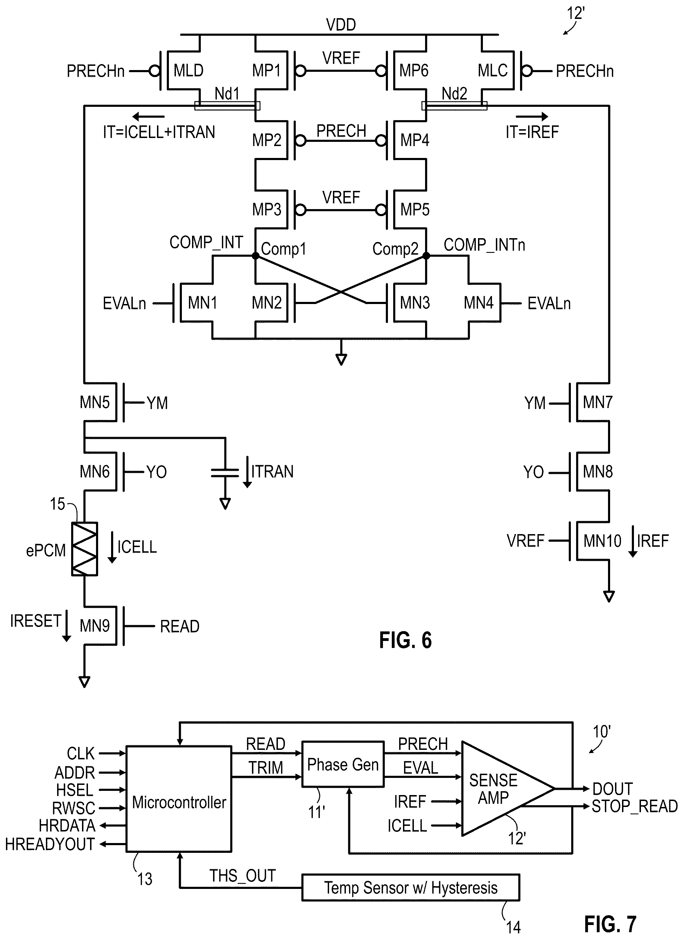

Now described with reference to FIG. 6 is a sense amplifier 12' for use in reading an ePCM cell 15. The sense amplifier 12' includes: a first pre-charge transistor MLD (e.g., p-channel MOSFET) having its source coupled to a supply voltage VDD, its drain connected to a first node Nd1, and its gate coupled to receive a negated version PRECHn of the precharge signal PRECH; and a second pre-charge transistor MLC (e.g., p-channel MOSFET) having its source coupled to the supply voltage VDD, its drain connected to a second node Nd2, and its gate coupled to receive the active-low version PRECHn of the precharge signal PRECH.

The sense amplifier 12' further includes: p-channel MOSFET transistor MP1 having its source coupled to the supply voltage VDD, its drain connected to the first node Nd1, and its gate coupled to a reference voltage VREF; p-channel MOSFET transistor MP2 having its source connected to the first node Nd1, and its gate coupled to the precharge signal PRECH; p-channel MOSFET transistor MP3 having its source connected to the drain of p-channel transistor MP2, its drain connected to intermediate node Comp1, and its gate coupled to the reference voltage VREF; p-channel MOSFET transistor MP6 having its source coupled to the supply voltage VDD, its drain connected to the first node Nd2, and its gate coupled to a reference voltage VREF; p-channel MOSFET transistor MP4 having its source connected to the first node Nd2, and its gate coupled to the precharge signal PRECH; and p-channel MOSFET transistor MP5 having its source connected to the drain of p-channel transistor MP4, its drain connected to intermediate node Comp2, and its gate coupled to the reference voltage VREF.

The sense amplifier 12' includes a comparator (e.g., cross-coupled differential pair) formed by: n-channel MOSFET transistor MN1 having its drain connected to node Comp1, its source coupled to ground, and its gate coupled to the active low version EVALn of the evaluation signal EVAL; n-channel MOSFET transistor MN2 having its drain connected to node Comp1, its source coupled to ground, and its gate coupled to node Comp2; n-channel MOSFET transistor MN3 having its drain connected to node Comp2, its source coupled to ground, and its gate coupled to node Comp1; and n-channel MOSFET transistor MN4 having its drain connected to node Comp2, its source coupled to ground, and its gate coupled to the active low version EVALn of the evaluation signal EVAL. A differential comparison signal COMP_INT, COMP_INTn are formed at nodes Comp1, Comp2.

A cell branch is formed by: n-channel MOSFET transistor MN5 having its drain connected to node Nd1, and its gate connected to signal YM; n-channel MOSFET transistor MN6 having its drain connected to the source of n-channel transistor MN5, its source connected to the first terminal of ePCM 15, and its gate coupled to signal YO; ePCM 15 having its first terminal connected to the source of n-channel transistor MN6 and its second terminal connected to the drain of n-channel MOSFET transistor MN9 having its source coupled to ground, and its gate coupled to the read signal READ.

A reference branch is formed by: n-channel MOSFET transistor MN7 having its drain connected to node Nd2, and its gate connected to signal YM; n-channel MOSFET transistor MN8 having its drain connected to the source of n-channel transistor MN7, and its gate coupled to signal YO; and n-channel MOSFET transistor MN10 having it drain connected to the source of n-channel transistor MN8, its source coupled to ground, and its gate coupled to the reference signal VREF.

The sense amplifier 12' operates in two main phases, precharge and evaluation, to read the state of the ePCM cell 15.

The precharge phase is now described. In the precharge phase, when the negated precharge signal PRECHn is asserted (active low) and the negated evaluation signal EVALn is deasserted (active low), transistors MLD and MLC turn on, precharging nodes Nd1 and Nd2 to VDD, and transistors MP2 and MP4 turn off, isolating the upper part of the sense amplifier 12' from the comparator. The prepares the cell branch (with transistor MN5, transistor MN6, ePCM 15, and transistor MN9) and reference branch (with transistors MN7, MN8, MN10) for the read operation which occurs during the evaluation phase.

In the evaluation phase, where the negated precharge signal PRECHn is deasserted (active low) and the negated evaluation signal EVALN is asserted (active low), transistors MLD and MLC turn off, while transistors MP2 and MP4 turn on, and therefore current begins to flow through both branches. In the cell branch, a current **IT** (ICELL + ITRAN) flows through MN5, MN6, ePCM 15, and MN9 (when READ is active), with ITRAN representing a parasitic current charging metallization wiring in the IC associates with accessing the ePCM cells.

In the reference branch, the reference current IREF flows through transistors MN7, MN8, and MN10. These currents are mirrored to the comparator inputs at nodes Comp1 and Comp2. The comparator formed by transistors MN1, MN2, MN3, MN4 activates when the negated evaluation signal EVALn is asserted (active low), amplifying the voltage difference between nodes Comp1 and Comp2.

The cross-coupled structure of the comparator provides positive feedback, quickly resolving to a stable state. If ICELL + ITRAN > IREF, node Comp1 will be pulled higher than node Comp2; conversely, if ICELL + ITRAN < IREF, node Comp2 will be pulled higher than node Comp1. The final states of signal COMP_INT (at node Comp1) and signal COMP_INTn (at node Comp2) therefore represent the read result: where signal COMP_INT being high and signal COMP_INTn being low indicates one state of the ePCM cell; and where signal COMP_INT being low and signal COMP_INTn being high indicates the opposite state.

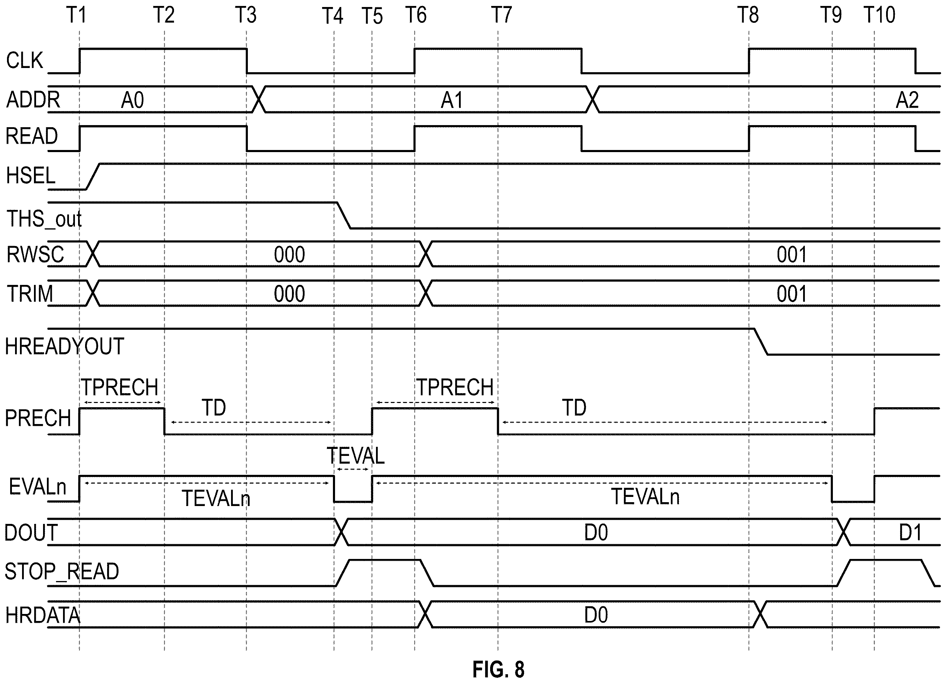

Keeping this in mind, a readout circuit 10' disclosed herein is now described with reference to FIG. 8. The readout circuit 10' includes microcontroller 13 that receives the clock signal CLK, the address signal ADDR, the HSEL signal, the RWSC signal, the HRDATA signal, and the HREADYOUT signal. The microcontroller 13 in turn generates the read signal READ, as well as a trim signal TRIM, which are used by the phase generation circuit 11' in generating the precharge signal PRECH and the evaluation signal EVAL. The sense amplifier 12', as described above, compares the cell current ICELL to the reference current IREF, under control of the precharge signal PRECH and evaluation signal EVAL, to generate the output DOUT (the differential output COMP_INT, COMP_INTn).

Of note is that the microcontroller 13 also receives a temperature sensor output THS_OUT from a hysteretic temperature sensor 14, and generates the trim signal TRIM based upon the temperature sensor. The trim signal TRIM is used by the phase generation circuitry 11' to set the duration of the time between deassertion of the precharge signal TPRECH and the assertion of the evaluation signal EVAL.

The microcontroller 13 interfaces with the ePCM array through an AMBA (Advanced Microcontroller Bus Architecture) bus protocol. Signals of interest in this protocol are CLK, ADDR, HSEL, RWSC, HRDATA, and HREADYOUT.

The HSEL (Host Select) signal when high, indicates that the current transfer is intended for this particular memory device; the RWSC (Read/Write Status Control) signal represents the insertion of wait states, indicating whether a regular read operation is being performed or whether a slow read operation is being performed in which a one-cycle wait state is inserted; the HRDATA signal is the data output bus, carrying the actual data read from the ePCM array, corresponding to the address provided in ADDR; and the HREADYOUT signal indicates the status of the current transfer, signaling that a transfer has finished on the bus when high and extending a transfer by inserting wait states when low.

A temperature sensor with hysteresis 14 outputs a temperature high signal THS_OUT logic high when the temperature exceeds 10°C and logic low when below this threshold. The hysteresis in this temperature sensor 14 provides a "buffer zone" around the 10°C threshold to prevent rapid oscillations in the output signal due to small temperature fluctuations. Typically, the sensor might turn on (output high) at 10°C when the temperature is rising, but not turn off (output low) until the temperature drops to, for example, 8°C. This difference between the turn-on and turn-off temperatures is the hysteresis band. The hysteresis provides for more stable operation by reducing the likelihood of the system rapidly switching between states near the threshold temperature. This temperature information is used to adapt the read process, as explained, for performance and reliability across different temperature conditions.

The system operates on a clock CLK in the MHz range. At each rising edge of the clock CLK, the microcontroller 13 latches the address ADDR for the memory location to be read. The HSEL signal, when high, indicates that a data transfer is intended.

The phase generation circuit 11' receives control signals from the microcontroller 13, including the signals READ and TRIM, and generates the necessary timing signals (PRECH and EVAL) for the sense amplifier 12'. The sense amplifier 12' compares the cell current ICELL from the selected ePCM cell with a reference current IREF to determine the stored data value.

The RWSC signal controls the insertion of wait states, allowing the system to adapt its timing. When the signal THS_OUT is logic low (indicating lower temperature), a slow read is initiated by inserting a wait state, which is reflected by the signal HREADYOUT going low. This extends the transfer time, ensuring reliable reads at lower temperatures where the ePCM cells may respond more slowly. When the signal THS_OUT is logic high (indicating higher temperature), no wait is initiated, and thus the transfer time occurs more quickly. The signal HREADYOUT, when high, indicates that a transfer has finished on the bus. The signal HRDATA is the output bus on which the PCM array content is made available, corresponding to the address provided in the address signal ADDR.

The operation of the readout circuit 10' can be described in detail with reference to the timing diagram shown in FIG. 8, which illustrates the relationship between various signals during read operations of the ePCM memory cell 15.

At time T1, the rising edge of the clock CLK initiates a read operation as the READ signal is asserted. The address bus has been preloaded with a first address A0, and the host select HSEL signal goes high, indicating that this ePCM memory cell 15 is selected. The temperature sensor output THS_OUT is initially high, indicating the temperature is above the desired threshold (e.g., 10°C). Consequently, the read/write status control RWSC signal and the TRIM signal are set to '000', indicating a regular read operation without wait states. Additionally, the precharge signal PRECH is asserted, beginning the precharge phase of the read operation.

At time T2, PRECH is deasserted, ending the precharge period. The duration between T1 and T2, labeled as TPRECH in FIG. 8, represents the precharge period. Concurrently, the active-low version of the evaluation signal EVALn remains high, preparing for the evaluation phase.

At time T3, the READ signal is deasserted, and the next address A1 is loaded onto the address bus, in preparation for the subsequent read operation.

Time T4 is the beginning of the evaluation period as EVALn is asserted (goes low). This evaluation period continues until T5. The STOP_READ signal is also asserted at T4, indicating the end of the current read cycle. The time delay between the deassertion of PRECH at T2 and the deassertion of EVALn at T4 is denoted as TD. The time delay between EVALn going high at time T1 and EVALn going low at T4 is labeled at TEVALn.

At T5, PRECH is reasserted, initiating another precharge period for the next read operation. The time between T4 and T5, labeled as TEVAL, represents the evaluation period.

At T6 is the arrival of another CLK edge, and the READ signal is reasserted, beginning the next read cycle. THS_OUT is now low, indicating that the temperature has dropped below the desired threshold. In response, RWSC and TRIM signals are set to '001', indicating the need for a wait state insertion. The STOP_READ signal is deasserted at this point, allowing the new read operation to proceed.

At T7, PRECH is deasserted, concluding the precharge period that began at T5. The duration between T5 and T7, TPRECH, represents this extended precharge period. Due to the lower temperature condition, EVALn remains high beyond the next clock edge at T8.

At T8, HREADYOUT is deasserted, indicating the insertion of a wait state. The STOP_READ signal is also asserted at this time.

At T9, EVALn is goes low again, initiating an extended evaluation period that continues until T10. The time delay between T7 and T9, also labeled TD, is longer than the TD between T2 and T4, reflecting the adaptation to the lower temperature by providing more time for the read operation to resolve. The period between T5 and T9 is labeled as TEVALn.

Throughout this sequence, the HRDATA signal transitions reflect the output of data D0, D1 corresponding to the read addresses, with the timing adjusted based on the temperature conditions and inserted wait states.

This demonstrates how the ePCM readout circuit 10' dynamically adjusts its timing parameters in response to temperature changes, ensuring reliable read operations across varying conditions. The ability to extend precharge and evaluation periods, along with the insertion of wait states, showcases its adaptive nature in maintaining optimal performance of the ePCM memory cell.

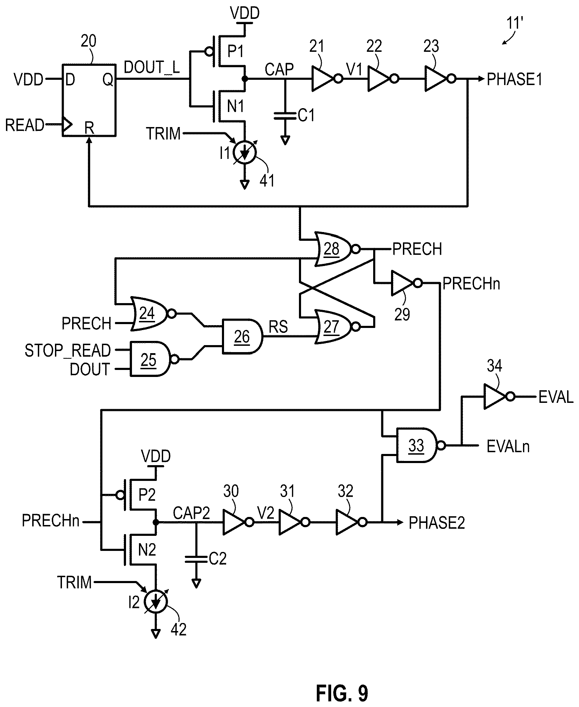

Further details of the phase generation circuitry 11' are now given with reference to FIG. 9. The phase generation circuitry 11' includes an input flip flop 20 clocked by the read signal READ, receiving the supply voltage VDD at its data input, and generating a DOUT_L signal (e.g., data output low) at its output. An inverter formed by p-channel transistor P1 and n-channel transistor N1 receives DOUT_L at its input and is connected to capacitor C1 at its output; p-channel transistor P1 has its source coupled to the supply voltage VDD, its drain connected to a first terminal of capacitor C1, and its gate coupled to receive DOUT_L, while n-channel transistor N1 has its drain coupled to the first terminal of capacitor C1, its source connected to current source 41 arranged as an adjustable current sink and sinking current I1 from the source of N1 (I1 being adjusted based on TRIM), and its gate coupled to receive DOUT_L. The first terminal of capacitor C1 is coupled to the drain of p-channel transistor P1, the drain of n-channel transistor N1, and the input of inverter 21, which in turn has its output in turn connected to the input of inverter 22, itself having its output connected to the input of inverter 23. A first phase signal PHASE1 is produced at the output of inverter 23.

A NOR gate 24 has inputs receiving the precharge signal PRECH as well as the output of NOR gate 27. A NAND gate 25 has inputs receiving the STOP_READ signal as well as the data output signal DOUT. A NAND gate 26 has inputs receiving the outputs of NOR gate 24 and NAND gate 25. The NOR gate 27 has inputs receiving the output of the NAND gate 26 as well as the precharge signal PRECH. A NOR gate 28 has inputs receiving the output of the NOR gate 27 as well as the PHASE1 signal. The precharge signal PRECH is output by the NOR gate 28. The active low version PRECHn of the precharge signal PRECH is generated by inverter 29.

An inverter formed by p-channel transistor P2 and n-channel transistor N2 receives PRECHn at its input and is connected to capacitor C2 at its output; p-channel transistor P2 has its source coupled to the supply voltage VDD, its drain connected to a first terminal of capacitor C2, and its gate coupled to receive PRECHn, while n-channel transistor N2 has its drain coupled to the first terminal of capacitor C2, its source connected to current source 42 arranged as an adjustable current sink and sinking current I2 from the source of N2 (I2 being adjusted based on TRIM), and its gate coupled to receive PRECHn. The first terminal of capacitor C2 is coupled to the drain of p-channel transistor P2, the drain of n-channel transistor N2, and the input of inverter 30, which in turn has its output in turn connected to the input of inverter 31, itself having its output connected to the input of inverter 32. A second phase signal PHASE2 is produced at the output of inverter 32. A NAND gate 33 has inputs receiving PRECHn and PHASE2, with EVALn being generated at its output, and with EVAL then being generated by inverter 34.

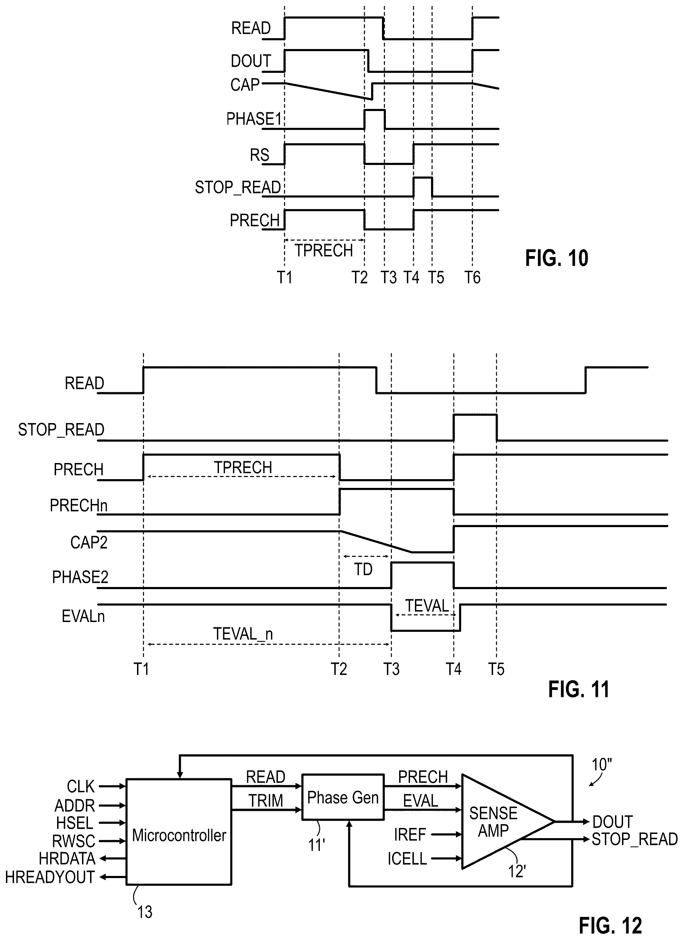

The operation of the phase generation circuitry 11' can be described in detail with reference to the timing diagrams shown in FIG. 10 and FIG. 11, which illustrate the relationship between various signals during the read operation of the ePCM memory. In FIG. 10, at time T1, the READ signal is asserted by the microcontroller 13, triggering the input flip flop 20 to generate the DOUT_L signal. Simultaneously, PRECH is asserted, beginning the precharge phase, and the voltage on capacitor C1 (labeled as CAP) begins to discharge through transistor N1 and current source 41. The time between T1 and T2 is defined as TPRECH, representing the duration of the precharge phase, and may be tuned through adjustment of the current sunk by the current source 41.

At T2, PHASE1 goes high as the CAP voltage crosses the threshold of inverter 21, causing PRECH to go low through NOR gate 28. Shortly after T2, DOUT transitions low, and CAP begins to recharge through transistor P1. At T3, the RS signal goes low, followed by STOP_READ going high at T4. These transitions cause PRECH to go high again at T5, initiating the next precharge phase. The cycle concludes at T6 when READ goes low, resetting the circuit for the next operation.

FIG. 11 provides a more detailed view of the subsequent phases, starting again at T1 with the assertion of READ and PRECH. The time between T1 and T2 is labeled TPRECH, during which PRECHn is deasserted, causing capacitor C2 to discharge through transistor N2 and current source 42.

At T2, PRECH goes low and PRECHn goes high, ending the precharge phase. The time between T1 and T2 is defined as TPRECH, representing the duration of the precharge phase, and may be tuned through adjustment of the current sunk by the current source 42.

The time between T2 and T3, labeled TD, represents the delay as CAP2 continues to discharge until it triggers PHASE2 to go high at T3. This rising edge of PHASE2, combined with the high state of PRECHn, causes EVALn to go low through NAND gate 33, initiating the evaluation phase. The duration between T1 and T3, labeled TEVALn, represents the total time EVALn is high before the evaluation phase begins. At T4, STOP_READ is asserted, which propagates through the logic gates to cause PRECH to go high and PRECHn to go low. Shortly after T4, EVALn returns to high as PRECHn goes low, ending the evaluation phase. The time between T3 and this point is labeled TEVAL, representing the duration of the evaluation phase. At T5, READ is deasserted, concluding the read cycle.

This timing sequence demonstrates how the phase generation circuit 11' uses the RC delays of capacitors C1 and C2, along with the adjustable current sources I1 and I2, to create the timing for the PRECH and EVALn signals.

Finally, it is evident that modifications and variations can be made to what has been described and illustrated herein without departing from the scope of this disclosure. For example, an embodiment for performing temperature sensing without the use of a temperature sensor is possible.

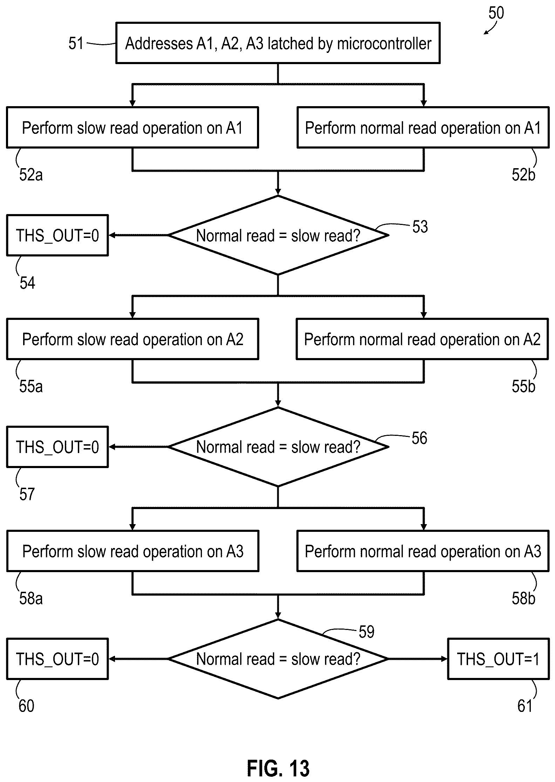

A thermal calibration method for the ePCM readout circuit 10' is now described with reference to FIGS. 12 and 13. Of note is that in this embodiment, the discrete temperature sensor 14 described previously is eliminated, with the thermal sensing functionality instead being implemented through the microcontroller 13 executing a thermal calibration procedure 50.

The thermal calibration procedure 50 utilizes the observation that the relationship between slow read and normal read operations varies predictably with temperature. At higher temperatures, where the ePCM cells respond more quickly, both slow and normal read operations should yield identical results. Conversely, at lower temperatures where cell response is slower, discrepancies may arise between slow and normal read results due to insufficient settling time in the normal read mode.

As shown in the block diagram of FIG. 12, the microcontroller 13 interfaces with the phase generation circuit 11' and sense amplifier 12' as previously described. However, the microcontroller 13 now implements the thermal calibration procedure 50 detailed in FIG. 13 to determine the appropriate setting for THS_OUT.

With reference to FIG. 13, the thermal calibration procedure 50 begins at Block 51 where the microcontroller 13 latches three addresses A1, A2, A3. These addresses are selected to span the ePCM array, typically including a lower address (A1), higher address (A2), and an intermediate address (A3), to ensure comprehensive sampling of array behavior.

For address A1, the procedure performs both a slow read operation (Block 52a) and a normal read operation (Block 52b). The results of these operations are compared (Block 53). If the normal read does not match the slow read, indicating insufficient settling time at the current temperature, the microprocessor sets THS_OUT=0 at Block 54 and proceeds to test the next address.

Similarly, for address A2, slow and normal read operations are performed at Blocks 55a and 55b respectively, with results compared by the microprocessor (Block 56). Again, any mismatch results in THS_OUT=0 being set at Block 57.

Finally, address A3 is tested through slow read (Block 58a) and normal read (Block 58b) operations, with comparison being performed by the microprocessor (Block 59). If all three addresses show matching results between slow and normal reads, indicating sufficient settling time across the array, THS_OUT is set to 1 at Block 61. Otherwise, THS_OUT is set to 0 at Block 60.

This thermal calibration method provides several advantages over the discrete temperature sensor approach. First, it directly measures the actual performance of the memory array rather than relying on ambient temperature measurement. Second, it can detect localized temperature variations that might affect only portions of the array. Third, it adapts to the specific timing characteristics of each individual device, accounting for process variations.

The thermal calibration procedure 50 can be executed periodically during device operation to ensure optimal timing adjustments as temperature conditions change. The microcontroller 13 can initiate the calibration sequence based on various triggers such as elapsed time, detected read errors, or external commands.

The THS_OUT value determined by the thermal calibration procedure 50 is then used by the microcontroller 13 to adjust read timing parameters through the TRIM signal as previously described, ensuring reliable operation across varying temperature conditions.

Although this disclosure has been described with a limited number of embodiments, those skilled in the art, having the benefit of this disclosure, can envision other embodiments that do not deviate from the disclosed scope. Furthermore, skilled persons can envision embodiments that represent various combinations of the embodiments disclosed herein made in various ways.

## Claims

1. A readout circuit for an embedded phase change memory (ePCM) cell, comprising:
a temperature sensor (14) configured to output a temperature signal (THS_OUT) indicative of whether a sensed temperature is above or below a threshold temperature;
a microcontroller (13) configured to generate a read signal (READ) and a trim signal (TRIM), the trim signal (TRIM) being generated based upon the temperature signal (THS_OUT);
a phase generation circuit (11') coupled to the microcontroller (13) and configured to receive the read signal (READ) and the trim signal (TRIM), and to generate a precharge signal (PRECH) and an evaluation signal (EVAL) based thereupon; and
a sense amplifier (12') coupled to the phase generation circuit (11') to receive the precharge signal (PRECH) and the evaluation signal (EVAL), the sense amplifier (12') being configured to compare, under timing control of the precharge signal (PRECH) and the evaluation signal (EVAL), a cell current from the ePCM cell (15) to a reference current (IREF) and generate an output signal (DOUT) based on the comparison.

2. The readout circuit of claim 1, wherein the phase generation circuit (11') is configured to set a duration of time between deassertion of the precharge signal (PRECH) and assertion of the evaluation signal (EVAL) based on the trim signal (TRIM).

3. The redout circuit of claim 1, wherein the temperature sensor (14) is hysteretic to prevent rapid oscillations in the temperature signal (THS_OUT) due to small temperature fluctuations near the threshold temperature.

4. The readout circuit of claim 1, wherein the microcontroller (13) is further configured to: set the trim signal (TRIM) to indicate insertion of a wait state based on the trim signal (TRIM), the wait state causing skipping of transition of the evaluation signal (EVAL) during a current read cycle.

5. The readout circuit of claim 1, wherein the phase generation circuit (11') comprises: a first delay circuit configured to generate the precharge signal (PRECH); and a second delay circuit configured to generate the evaluation signal (EVAL).

6. The readout circuit of claim 5, wherein the first delay circuit comprises: a first capacitor (C1); a first adjustable current source (41) coupled to the first capacitor (C1) and configured to discharge the first capacitor (C1); and a first set of inverters (21, 22, 23) coupled to the first capacitor (C1) and configured to generate the precharge signal (PRECH) based on a voltage across the first capacitor (C1).

7. The readout circuit of claim 6, wherein the second delay circuit comprises: a second capacitor (C2); a second adjustable current source (42) coupled to the second capacitor (C2) and configured to discharge the second capacitor (C2); and a second set of inverters (30, 31, 32) coupled to the second capacitor (C2) and configured to generate the evaluation signal (EVAL) based on a voltage across the second capacitor (C2).

8. The readout circuit of claim 10, wherein the first and second adjustable current sources (41, 42) are configured to be adjusted based on the trim signal (TRIM) received from the microcontroller (13).

9. The readout circuit of claim 8, wherein adjusting the first and second adjustable current sources (41, 42) based on the trim signal (TRIM) controls the delay between the deassertion of the precharge signal (PRECH) and the assertion of the evaluation signal (EVAL).

10. The readout circuit of claim 5, wherein the second delay circuit is triggered by a transition of the precharge signal (PRECH).

11. The readout circuit of claim 5, wherein the phase generation circuit (11') further comprises: a first logic circuit coupled to the first delay circuit and configured to control the assertion and deassertion of the precharge signal (PRECH); and a second logic circuit coupled to the second delay circuit and configured to control the assertion and deassertion of the evaluation signal (EVAL).

12. The readout circuit of claim 11, wherein the first logic circuit comprises: a first NOR gate (24) having inputs receiving the precharge signal (PRECH) and an output of a second NOR gate (28); a first NAND gate (25) having inputs receiving a stop read signal (STOP_READ) and a data output signal (DOUT); a third NOR gate (27) having inputs receiving an output of the first NAND gate (25) and the precharge signal (PRECH); and wherein the second NOR gate (28) has inputs receiving an output of the third NOR gate (27) and an output (PHASE1) of the first delay circuit.

13. The readout circuit of claim 11, wherein the second logic circuit comprises: a second NAND gate (33) having inputs receiving an inverted precharge signal (PRECHn) and an output (PHASE2) of the second delay circuit; and an inverter (34) coupled to an output of the second NAND gate (33) and configured to generate the evaluation signal (EVAL).

14. A readout circuit for a memory cell, comprising:
a temperature sensor (14) configured to output a temperature signal (THS_OUT) indicative of a sensed temperature;
a timing control circuit (11') coupled to the temperature sensor (14) and configured to: receive the temperature signal (THS_OUT); generate a precharge signal (PRECH) and an evaluation signal (EVAL) for reading the memory cell; and adjust a duration of time between deassertion of the precharge signal (PRECH) and assertion of the evaluation signal (EVAL) based on the temperature signal (THS_OUT); and
a sense amplifier (12') coupled to the timing control circuit (11') to receive the precharge signal (PRECH) and the evaluation signal (EVAL), the sense amplifier (12') being configured to compare a cell current from the memory cell to a reference current (IREF) and generate an output signal (DOUT) based on the comparison, under timing control of the precharge signal (PRECH) and the evaluation signal (EVAL).

15. The readout circuit of claim 14, wherein the timing control circuit (11') is configured to increase the duration of time between deassertion of the precharge signal (PRECH) and assertion of the evaluation signal (EVAL) when the sensed temperature is below a threshold temperature.

16. The readout circuit of claim 14, wherein the temperature sensor (14) is hysteretic to prevent rapid oscillations in the temperature signal (THS_OUT) due to small temperature fluctuations near a threshold temperature.

17. The readout circuit of claim 14, wherein the timing control circuit (11') is further configured to: insert a wait state based on the temperature signal (THS_OUT), the wait state causing skipping of transition of the evaluation signal (EVAL) during a current read cycle.

18. A readout circuit for an embedded phase change memory (ePCM) cell, comprising:
a microcontroller (13) configured to:
latch a plurality of test addresses spanning the ePCM cell (15);
perform both a slow read operation and a normal read operation at each of the plurality of test addresses;
compare results of the slow read operation and the normal read operation at each test address;
generate a temperature signal (THS_OUT) based on whether the slow read operation matches the normal read operation at each test address; and
generate a trim signal (TRIM) based upon the temperature signal (THS_OUT);
a phase generation circuit (11') coupled to the microcontroller (13) and configured to receive the read signal (READ) and the trim signal (TRIM), and to generate a precharge signal (PRECH) and an evaluation signal (EVAL) based thereupon; and
a sense amplifier (12') coupled to the phase generation circuit (11') to receive the precharge signal (PRECH) and the evaluation signal (EVAL), the sense amplifier (12') being configured to compare a cell current from the ePCM cell (15) to a reference current (IREF) and generate an output signal (DOUT) based on the comparison, under timing control of the precharge signal (PRECH) and the evaluation signal (EVAL).

19. The readout circuit of claim 18, wherein the plurality of test addresses comprises: a lower address in the ePCM cell; a higher address in the ePCM cell; and an intermediate address between the lower address and the higher address.

20. The readout circuit of claim 18, wherein the microcontroller (13) is configured to: set the temperature signal (THS_OUT) to a first value when the slow read operation matches the normal read operation at all test addresses; and set the temperature signal (THS_OUT) to a second value when the slow read operation differs from the normal read operation at any test address.

21. The readout circuit of claim 20, wherein: the first value indicates operation above a threshold temperature; and the second value indicates operation below the threshold temperature.

22. A readout circuit for a memory cell, comprising:
a sense amplifier (12') configured to compare a cell current from the memory cell to a reference current (IREF) and to generate an output signal (DOUT) based on the comparison; and
a timing control circuit (11') coupled to the sense amplifier (12') and configured to generate a precharge signal (PRECH) and an evaluation signal (EVAL) controlling the sense amplifier (12');
wherein the timing control circuit (11') adjusts a duration of time between deassertion of the precharge signal (PRECH) and assertion of the evaluation signal (EVAL) based on a temperature-dependent control signal (THS_OUT), such that the readout circuit adapts its read timing in response to temperature variations.

23. The readout circuit of claim 22, wherein the temperature-dependent control signal (THS_OUT) is generated by a temperature sensor (14) having hysteresis around a threshold temperature.

24. The readout circuit of claim 22, wherein the timing control circuit (11') inserts a wait state in a read cycle when the temperature-dependent control signal (THS_OUT) indicates a temperature below a threshold temperature.

25. The readout circuit of claim 22, wherein the timing control circuit (11') comprises a phase generation circuit (11') having adjustable current sources (41, 42) configured to set the timing of the precharge signal (PRECH) and the evaluation signal (EVAL) based on the temperature-dependent control signal (THS_OUT).

26. The readout circuit of claim 22, further comprising a microcontroller (13) configured to generate a trim signal (TRIM) based on the temperature-dependent control signal (THS_OUT), the trim signal (TRIM) being applied to the timing control circuit (11') to modify the duration between the precharge (PRECH) and evaluation (EVAL) signals.
